# EUROPEAN PATENT APPLICATION

(11) **EP 2 687 309 A2**
(43) Date of publication of application: **22.01.2014**
(21) Application number: 13177132.1
(22) Date of filing: 18.07.2013
(51) Int. Cl.: B23B 5/36

(54) **Workpiece having non-rotary curved surface machined by lathe**

(30) Priority: 20.07.2012 CN 201210252856
(71) Applicant: Fu Ding Electronical Technology (Jiashan) Co., Ltd., 314102 Jiashan Zhejiang (CN); Hon Hai Precision Industry Co., Ltd., New Taipei City (TW)
(72) Inventor: Yang, Ming-Lu, New Taipei (TW); Zhag, Tian-En, JIASHAN (CN); Zhang, Ya-Dong, JIASHAN (CN); Jia, Jian-Shi, JIASHAN (CN); Peng, Yang-Mao, JIASHAN (CN); Zhang, Wei-Chuan, JIASHAN (CN); Sui, Jing-Shuang, JIASHAN (CN); Qu, Jian, JIASHAN (CN); Chen, Feng-Hua, JIASHAN (CN); Jia, Jian-Hua, JIASHAN (CN); Qin, Xue, JIASHAN (CN); Tian, Zhen-Zhou, JIASHAN (CN); Li, Bao-Peng, JIASHAN (CN); Yu, Jian-Min, JIASHAN (CN)
(74) Representative: Gray, John James

(57) **Abstract**

A workpiece has non-rotary curved surface and edges. The workpiece is machined by a lathe. The lathe includes a cutter and a work table under the cutter. The worktable is configured for driving the workpiece to rotate. The non-rotary curved surface of the workpiece has a good finish because the cutter moves along a spiral cutting path on the workpiece at high speed continuously during the machining.

## Description

### BackGround

### Field

The present disclosure generally relates to workpieces, and particularly, to a workpiece having a non-rotary curved surface machined by lathe.

### BackGround

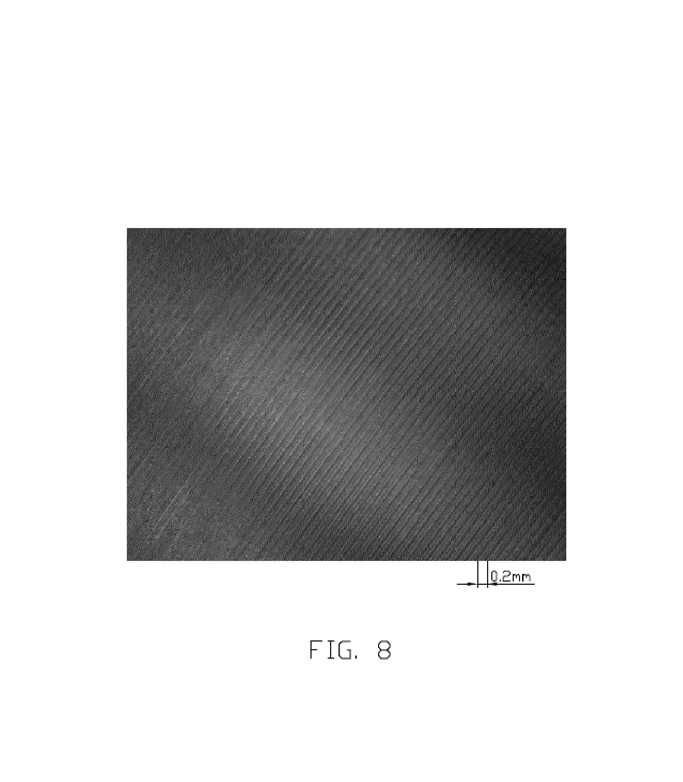

In the manufacturing field, a work table of a lathe is designed to be rotated, and the cutter is adopt a linear feeding mode. A workpiece having rotary curved surfaces can be machine by the lathes. Milling cutters are used to machine curved surfaces. FIG. 8 shows a magnified photo of a workpiece having a non-rotary curved surface which is machined after a conventional milling process. A milling cutter with different cutting edges is used for machining curved surfaces. Some tracks are formed on the milled surface of a workpiece because of intermitted contact and interrupted milling by the milling cutter. The average milled surface roughness of the workpiece shown in FIG. 8 is 5 microns. A polish process needs to be added for a better appearance.

Therefore, there is room for improvement within the art.

### Summary

According to one aspect of the disclosure, a workpiece has non-rotary curved surface and edges. The workpiece is machined by a lathe. The lathe includes a cutter and a work table under the cutter. The worktable is configured for driving the workpiece to rotate. The non-rotary curved surface of the workpiece has a good finish because the cutter moves along a spiral cutting path on the workpiece at high speed continuously during the machining.

### BRIEF DESCRIPTION OF THE DRAWING

The components in the drawings are not necessarily drawn to scale, the emphasis instead placed upon clearly illustrating the principles of the present disclosure. Moreover, in the drawings, like reference numerals designate corresponding parts throughout the several views.

FIG. 1 is an isometric view of an embodiment of a lathe having a cutter.

FIG. 2 is an isometric and partial view of the lathe of FIG. 1.

FIG. 3 is an isometric and exploded view of the lathe of FIG. 2.

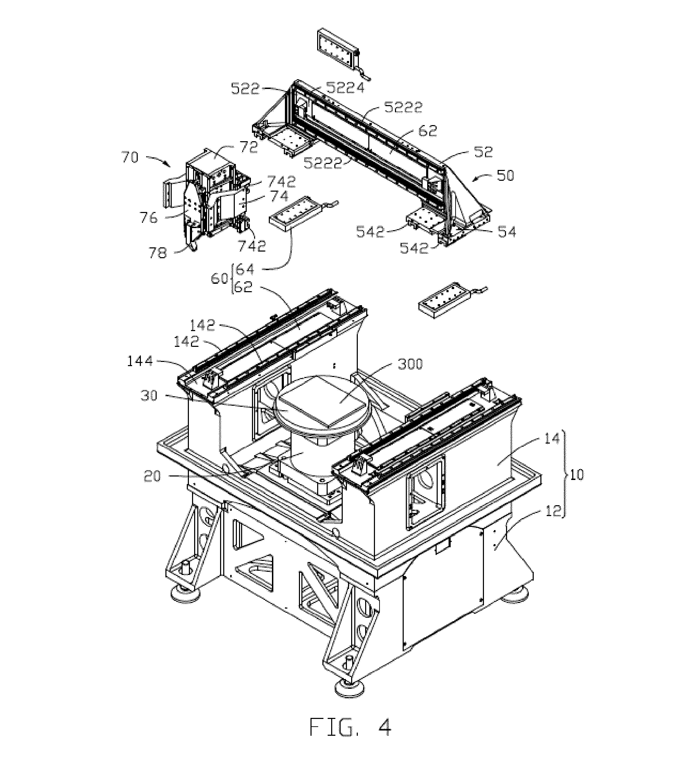

FIG. 4 is an isometric view of a workpiece having a curved surface machined by the lathe of FIG.1.

FIG. 5 a sectional view of the workpiece of the FIG. 4 along a direction VI -VI.

FIG. 6 is a top plan view of a planar cutting path of the cutter machining the workpiece of FIG. 1.

FIG. 7 is a magnified photo of the workpiece of the FIG. 4.

FIG. 8 is a magnified photo of a workpiece having non-rotary curved surfaces machined by conventional milling process.

### DETAILED DESCRIPTION

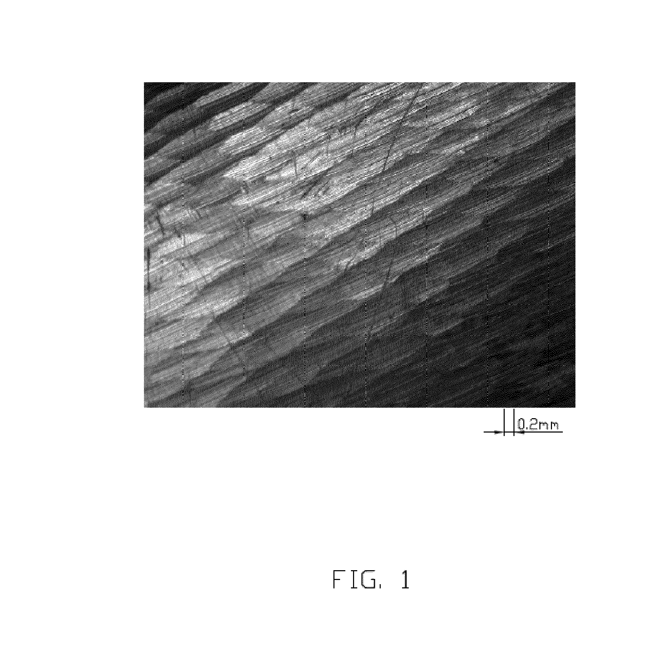

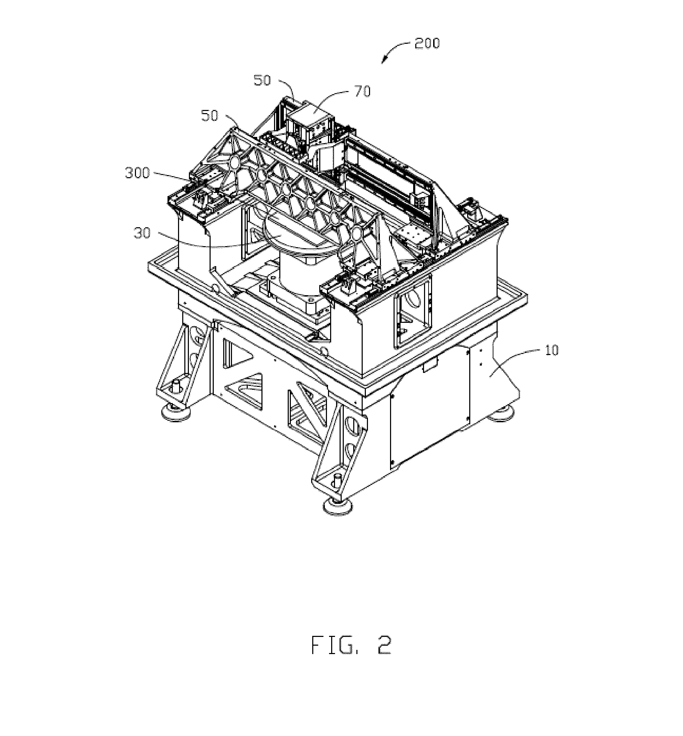

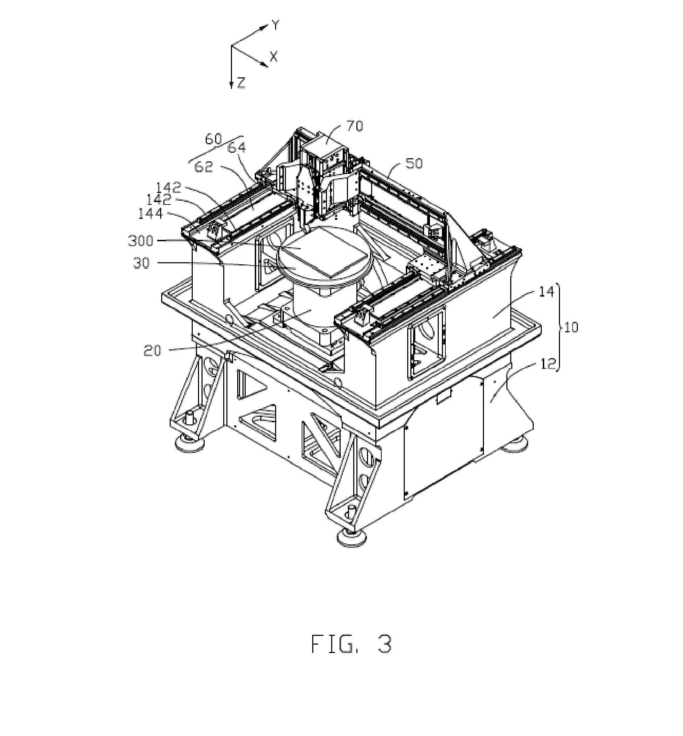

FIGS. 1 to 3 show an embodiment of a lathe 200. The lathe 200 is used for machining curved surface on a workpiece 300 in a single operation. The lathe 200 includes a machine support 10, a rotating driver 20, a work table 30, two cross beams 50, four driving mechanisms 60, and a feeding device 70. The work table 30 holds the workpiece 300 in place, and is supported by the machine support 10. The cross beams 50 are slidably positioned on the machine support 10 above the work table 30. The feeding device 70 is slidably assembled between the cross beams 50. The feeding device 40 can be driven to move along the three axes, X, Y, and Z.

The machine support 10 includes a base 12 and a pair of support bodies 14 positioned substantially parallel to each other on the base 12. Two spaced first sliding rails 142 are positioned in parallel on a surface of each support body 13 away from the base 12. In the illustrated embodiment, the first sliding rails 142 extend substantially parallel to the Y-axis. A first receiving groove 144 is formed on each support body 13 between the corresponding two first sliding rails 142.

The work table 30 is substantially cylindrical, and rotatably positioned on the base 12 via a rotating driver 20 between the two support bodies 14. In the illustrated embodiment, the rotating driver 20 is a direct drive motor.

Two cross beams 50 are oppositely slidably positioned on the support bodies 13 and extend substantially parallel to the X-axis to provide high stability. In the illustrated embodiment, opposite ends of each of the cross beams 50 respectively slidably engage with a corresponding pair of the first sliding rails 142. Each cross beam 50 includes a support portion 52 and two fixing portions 54 positioned at opposite ends of the support portion 52. A sliding surface 522 is positioned on the support portion 52. Two spaced second sliding rails 5222 are positioned on each sliding surface 522 and extend substantially parallel to the X-axis. A second receiving groove 5224 is formed on each sliding surface 522 between the two second sliding rails 5222. Two sliding surfaces 522 are positioned face to face and substantially perpendicular to the work table 30. The fixing portions 54 are substantially rectangular. Two first guiding blocks 542 are positioned substantially parallel to each other on a bottom surface of each fixing portion 54 to slidably engage with the first guiding rails 142. In the illustrated embodiment, the first guiding blocks 542 are U-shaped.

In the illustrated embodiment, the driving mechanisms 60 are linear motors. Each driving mechanism 60 includes a stator 62 and a rotor 64 moving linearly relative to the stator 62. Two of the driving mechanisms 60 are configured to drive the cross beams 50 to move along the first sliding rails 142. One stator 62 is received in each of the first receiving grooves 144, and one rotor 64 is fixedly installed on each fixing portion 54 of one of the cross beams 50. The other two driving mechanisms 60 are configured to drive the feeding device 70 to move along the second sliding rails 5222. One stator 62 is received in each of the second receiving grooves 5224, and two rotors 64 are fixedly mounted on opposite surfaces of the feeding device 70 facing the cross beams 50.

The feeding device 70 is slidably assembled between the two cross beams 50. The feeding device 70 includes a feeding driving mechanism 72, a mounting seat 74, a tool holder 76, and a cutter 78. The mounting seat 74 sleeves on the feeding driving mechanism 72. Corresponding to the second sliding rails 5222, two second guiding blocks 742 are positioned substantially parallel on each opposite side of the mounting seat 74, which are positioned adjacent to the corresponding cross beam 50. Shapes of the second guiding blocks 742 are similar to the first guiding blocks 542. The second guiding blocks 742 slidably engage with the second sliding rails 5222. One rotor 64 is positioned on each opposite side of the mounting seat 74 having the second guiding blocks 742. The feeding drive mechanism 72 is configured to drive the cutter 78 to move back and forth along the Z-axis. In the illustrated embodiment, the feeding driving mechanism 72 is a linear motor. The tool holder 76 is slidably assembled with the feeding driving mechanism 72. The cutter 78 is fixedly installed on a bottom of the tool holder 76.

In other embodiments, the feeding driving mechanism 72 can be omitted, and the tool holder 76 is fixedly mounted on the mounting seat 74. Furthermore, both the feeding driving mechanism 72 and the mounting seat 74 can be omitted, and the tool holder 76 is directly slidably assembled with the two cross beams 50, resulting in a lower cost lathe 100 and the assembly of the lathe 100 will be more convenient with a simpler structure.

In assembly, the work table 30 is positioned between the two support bodies 14. The cross beams 50 are installed on the two support bodies 14, and the first guiding blocks 542 slidably engage with the first sliding rails 142. The second guiding blocks 742 of the feeding device 70 are slidably connected to the second sliding rails 5222 for positioning the feeding device 70 between the cross beams 50.

In use, the workpiece 300 is placed on the work table 30. The rotating driver 20 rotates the work table 30 and the workpiece 300, the feeding device 70 is driven to move along the X-axis, the cross beams 50 are driven to move along the first sliding rails 142 along the Y-axis, and the feeding driving mechanism 72 drives the tool holder 76 and the cutter 78 to move back and forth along the Z-axis to machine the workpiece 300.

In other embodiments, if a cutting process only requires a small lathe 100 with lightweight parts, then to simplify the structure of the lathe 100 and lower costs, the number of the first sliding rails 142 on each support body 14 can be one, and the number of the first guiding blocks 542 on each fixing portion 54 is one, corresponding to the first sliding rail 142 for a more simpler structure and a lower cost of the lathe 100. The number of the second sliding rails 5222 on each cross beam 50 can also be one, and the number of the second guiding blocks 742 on a surface of the mounting seat 74 is one, corresponding to the second sliding rail 5222.

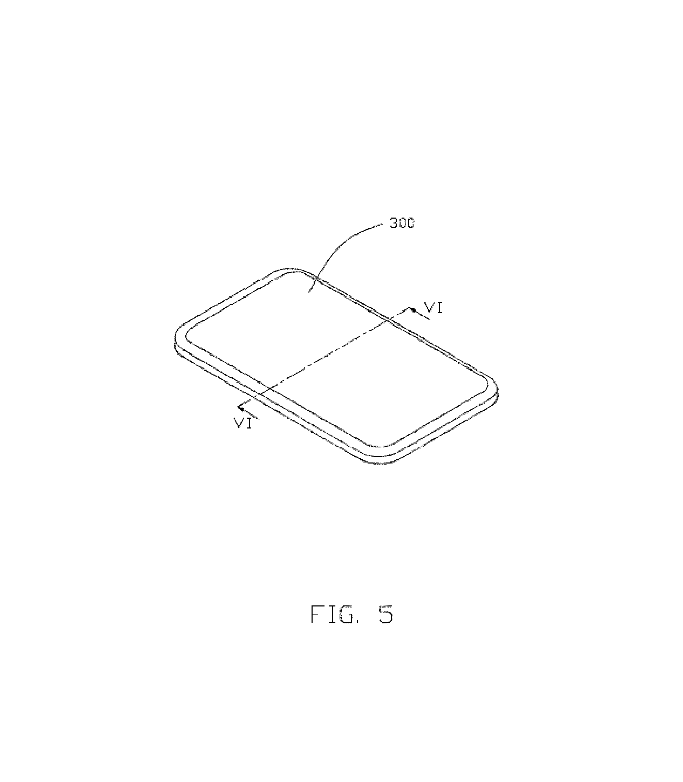

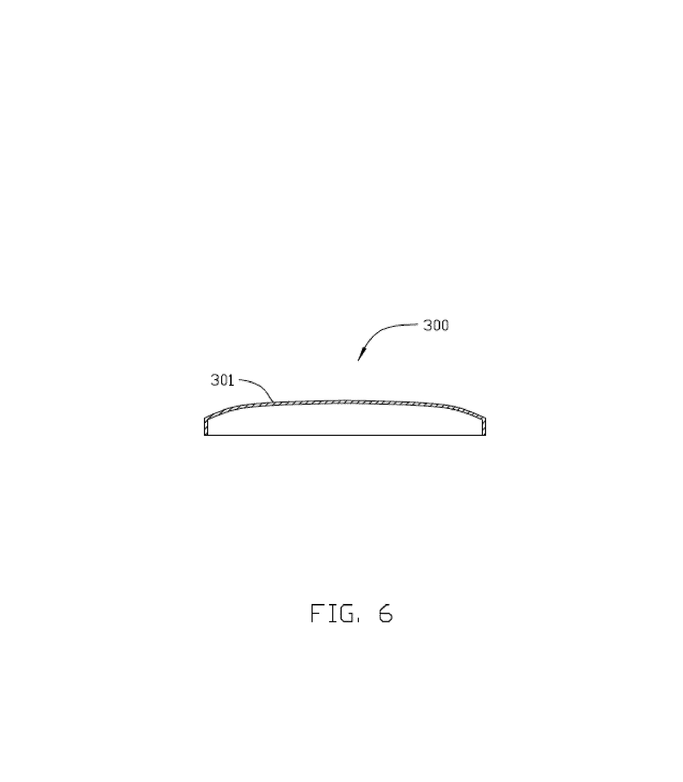

FIGS. 5 and 6 illustrate an embodiment of the workpiece 300 having a curved surface 301 is a housing of a panel computer. The workpiece 300 is made of aluminum alloy. The workpiece 300 is substantially a rectangular hollow board. The curved surface 301 is non-rotary curved surface. Radius of curvature of the curved surface 301 gradually decreases from a middle portion of the curved surface 301 to the edges of the workpiece 300. In other embodiments, the workpiece 300 may be made of other metal or alloy according to real-applications, such as magnesium alloy, aluminum, and stainless steal. The workpiece 300 can be a housing of a notebook, a computer integrated machine, or a television.

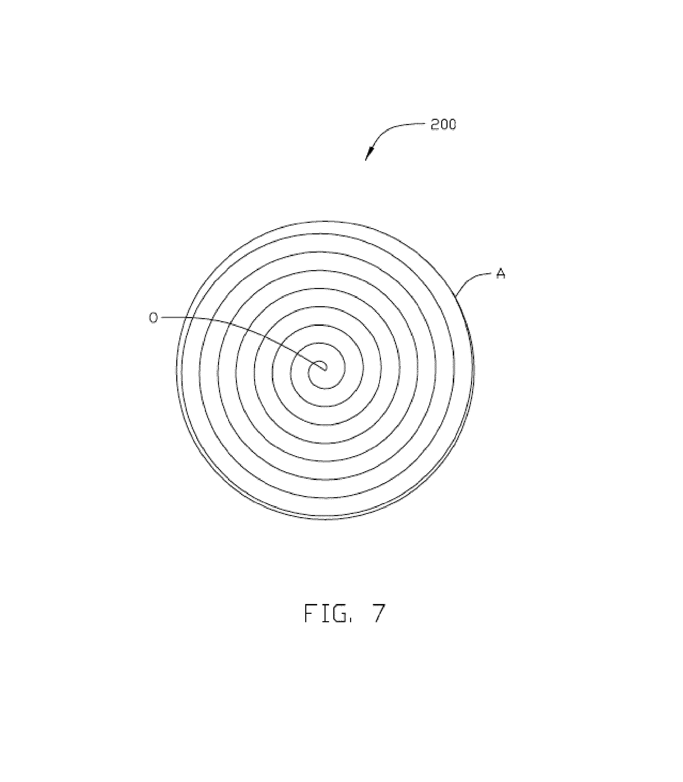

FIGS. 7 and 8 show that in process, control parameters for machining the workpiece 300 is input via an input pad (not shown) of the lathe 100 (not shown). A Y-axis coordinate α is a fixed value. The motion rang of the cutter 78 moving along the X-axis is from 0 to path distance β. The velocity v of the cutter 78 is defined as v= β/t, wherein t is machining time of the lathe 100. The cutter 78 moves along the X-axis from the start machining to completion machining. A starting position is a point Λ of an edge of the workpiece 300, and the terminal position is a center point Ω of the workpiece 300. The parameters of the frequency is µ, the cutter distance as ξ for the cutter 78 moving back and forth along the Z-axis, and the revolution as γ of the work table 20. The α, β, γ, v, t, and µ are fixed values during the machining. The value of the cutter distance ξ is decreased with the motion of the feeding device 70 along the X-axis. In the illustrated embodiment, the revolutionγis about 600 revolutions per minute and the frequency µ is about 2400 times per minute.

Two of the driving mechanisms 60 drive the feeding device 70 to move along the Y-axis. The feeding device 70 finally arrives at a preset position after moving the path distance β, which is above of the starting position Λ of an edge of the workpiece 300. Then the other two driving mechanisms drive the feeding device 70 to advance along the X-axis at the velocity v, the rotating driver 20 drives the work table 60 to rotate at the revolution γ. In addition, the feeding device 70 brings the cutter 78 to move back and forth along the Z-axis at the frequencyµand the cutter distance ξ is decreased with the motion of the cutter 78.

During the machining process, a planar cutting path of the cutter 78 is a spiral. The cutter 78 begins to turn the workpiece 300 at the stating position Λ, then moves to the terminal position Ω along the spiral path for machining the three dimensional curved surface 301. FIG. 7 shows a photo of a partial curved surface 301 of the workpiece 300 after machined by the lathe 100. The average surface roughness of the curved surface 301 is about 0.5 micron after test. In other embodiments, the range of the revolution γ is from about 100 revolutions per minute to about 800 revolutions per minute, the range of the frequencyµis about from 400 times per minute to about 3200 times per minute, and the average surface roughness of the curved surface 301 after machined is from about 0.2 micron to about micron 1.0 micron. A track retained on the workpiece 300 after the machining is continuous spiral shape.

In other embodiments, with changes in a relationship between the frequency µ and the cutter distance ξ of the cutter 70 according to the changeable machining time t, three dimensional curved surfaces with different shapes will be obtained under the control of the lathe control system 200.

In other embodiments, coordinate of the X-axis may be a fixed value to replace the fixed coordinate of the Y-axis in the illustrated embodiment, then the feeding module 30 moves along the Y-axis after arriving at a starting position during the machining.

The feeding device 70 and the cutter 78 is driven to move along the X-axis or the Y-axis, the rotating driver module 20 rotates the workpiece 300, and the feeding device 70 also drives the cutter 78 to move back and froth along the Z-axis at high speed continuously. Thereby, the cutter 78 moves along a spiral cutting path on the workpiece 300 for maximum quality appearance. No other process needs to be added to the machining of the workpiece 300 after being machined by the Iathe100.

While the present disclosure has been described with reference to particular embodiments, the description is illustrative of the disclosure and is not to be construed as limiting the disclosure. Therefore, various modifications can be made to the embodiments by those of ordinary skill in the art without departing from the true spirit and scope of the disclosure, as defined by the appended claims.

## Claims

1. A workpiece comprising a non-rotary curved surface and a plurality of edges, wherein the curved surface extends to the edges of the workpiece, and the workpiece is machined by a lathe comprising a feeding device and a work table for driving the workpiece to rotate, the feeding device comprises a feeding mechanism and a cutter, and the feeding mechanism is configured for driving the cutter to move backwards and forwards along a spiral cutting path to machine the workpiece under precise control.

2. The workpiece of claim 1, wherein the workpiece is made of a material selected from the group consisting of aluminum alloy, aluminum, magnesium alloy, and stainless steal.

3. The workpiece of claim 1, wherein the workpiece is a housing of an electronic device selected from the group consisting of a panel computer, a notebook, a computer integrated machine, and a television.

4. The workpiece of claim 1, wherein an average surface roughness of the curved surface is in a range from about 0.2 micron to about 1.0 micron.

5. The workpiece of claim 1, wherein the workpiece is a hollow rectangular board, and the radius of curvature of the curved surface gradually decreases from a middle portion of the curved surface to the edges of the workpiece.

6. The workpiece of claim 1, wherein a spiral track is retained on the workpiece after the cutter machining.

7. The workpiece of claim 1, wherein a frequency of the cutter moving back and forth is from about 400 times per minute to about 3200 times per minute.

8. The workpiece of claim 7, wherein a revolution of the work table is from about 100 revolutions per minute to about 800 revolutions per minute.

9. The workpiece of claim 8, wherein the frequency of the cutter moving back and forth is about 2400 times per minute, and the revolution of the work table is about 600 revolutions per minute.
